Europäisches Patentamt

European Patent Office  (·) Publication number: **0 367 705**

Office européen des brevets  **A2**

# EUROPEAN PATENT APPLICATION

(21) Application number: 89480148.9

(51) Int. Cl.5: **B23K 26/00** , **B23K 20/10**

(22) Date of filing: 26.09.89

(30) Priority: 31.10.88 US 264427

(43) Date of publication of application:
09.05.90 Bulletin 90/19

(84) Designated Contracting States:
**DE FR GB**

(·) Applicant: International Business Machines
Corporation
Old Orchard Road
Armonk, N.Y. 10504(US)

(72) Inventor: **Chalco, Pedro Armengo**
**780 Blackberry Lane**
**Yorktown Heights, N.Y. 10598(US)**
Inventor: **Gupta, Arunava, NMN**
**7 Flower Lane**
**Valley Cottage, N.Y. 10989(US)**
Inventor: **Hodgson, Rodney Trevor**
**822 Pinesbridge Road**
**Ossining, N.Y. 10562(US)**
Inventor: **Hu, Dyi-Chung, NMN**

**23 Lormar City**
**Wappingers Falls, N.Y. 12590(US)**
Inventor: **Hussey, Brian Washburn**
**South Mountain Pass**
**Garrison, N.Y. 10524(US)**
Inventor: **Interrante, Mario John**
**11 Meadow Road**
**New Paltz, N.Y. 12561(US)**
Inventor: **Ray, Sudipta Kumar**
**23 Rolling Green Lane**
**Wappingers Falls, N.Y. 12590(US)**
Inventor: **Seshan, Krishna, NMN**
**45 Tilden Avenue**
**Beacon, N.Y. 12508(US)**
Inventor: **Shaapur, Farhad, NMN**
**7001 East Palm Lane Apt. B-211**
**Scottsddale Arizona 85257(US)**

(74) Representative: **Colas, Alain**
**Compagnie IBM France Département de**
**Propriété Intellectuelle**
**F-06610 La Gaude(FR)**

(54) Laser assisted ultrasonic bonding.

(57) Disclosed is a bonding apparatus (10) which includes a bonding tip (12) at least a part of which is conically shaped having an open end and a closed end and tapering from the open end to the closed end, a source of ultrasonic energy (14) cooperatively engaged with the bonding tip, a source of laser energy (16), and an optical fiber (18) extending from the laser energy source to the interior of the bonding tip, the optical fiber being capable of transmitting a laser beam from the laser energy source to the closed end of the bonding tip so as to locally heat the closed end. In a preferred embodiment, the bonding apparatus is used for bonding discrete wires (32).

FIG. 1

# LASER ASSISTED ULTRASONIC BONDING

This invention relates to the apparatus for bonding surfaces together and, more particularly, relates to the use of laser and ultrasonic energy for the bonding.

Laser energy and ultrasonic energy have been combined for use in many different types of applications. For example, Webster U.S-A 4.576.177, the disclosure of which is incorporated by reference herein, discloses an arrangement for removing plaque deposits. The plaque deposits are identified by ultrasonic echoes and then are blasted by laser irradiation. The laser beam is transmitted to the precise location by an optical fiber.

More to the point, various processes and apparatus utilizing laser and ultrasonic energy have been proposed for the bonding of surfaces together. For example, Farrow U.S-A 4.330.669, the disclosure of which is incorporated by reference herein, discloses the application of a laser beam directly on the surface to be bonded, to cause melting thereof, while the laser beam is ultrasonically modulated. For many applications, such laser welding is not desirable since melting of the bonded surface occurs.

Ainslie et al. U.S-A 4.534.811, the disclosure of which is incorporated by reference herein, discloses an apparatus for bonding surfaces wherein the bonding tip of the apparatus is heated by a laser beam applied to the interior of the tip. Ultrasonic energy may then be applied to the tip, if desired, to result in a thermosonic bonding operation. The difficulty with such an apparatus is that it would be difficult to reliably focus the laser beam into the tip while the tip was undergoing modulation. The portion of the laser beam that does not make it into the tip would be wasted and, perhaps more importantly, would represent a danger to the operator of the apparatus.

More recently, Ehrenberg et al., Research Disclosure, July 1986, Number 267, and Chalco et al., Semiconductor International, pp. 130-131, May 1988, the disclosures of which are incorporated by reference herein, have disclosed a laser bonding apparatus wherein a laser beam is transmitted to the bonding tip by fiber optic cable. The end of the bonding tip is open so that part of the energy from the laser beam is utilized to heat the bonding tip and part is utilized to directly heat and melt the surface to be bonded. No ultrasonic energy is applied in this operation. Melting of the surface to be bonded necessarily occurs due to the direct impingement of the laser beam on the surface.

An important application of the thermosonic bonding of Ainslie et al. and the laser bonding of Chalco et al. is the discrete wire bonding of fine wires for surface interconnections in multilayer ceramic (MLC) packaging. While the discussion of the present invention will center on discrete wire bonding, the invention should not be construed as being limited to only discrete wire bonding. The present invention has applicability to many other bonding and applications which should be considered to be contemplated within the scope of the present invention.

In MLC packaging, each chip site is surrounded by engineering change (EC) pads. When an engineering change is desired to be made, a new interconnection is made by bonding a fine wire between predetermined EC pads. In a typical MLC package, the chip sites are covered with a thin layer of gold while the EC pads are covered with a much thicker layer of gold which is necessary to accommodate present-day bonding processes.

The fact that the chip sites and EC pads are covered with two different thicknesses of gold leads to manufacturing complications in that the chip sites must be masked off while extra gold is deposited on the EC pads. This requires further manufacturing steps which add to the final cost of the product as well as its complexity. Obviously, it would be desirable to have the same thickness of gold on the EC pads as there is on the chip sites. Unfortunately, attempts to bond to so-called "thin gold" (about 2500 Å) have been largely unsuccessful. There thus remains a definite need to be able to bond, and particularly wire bond, to thin gold surfaces.

Accordingly, it is an object of the present invention to be able to bond surfaces together which heretofore have been difficult to bond to.

It is an another object of the present invention to bond surfaces together with an apparatus and method that reduces the complexity of manufacturing.

It is a further object of the present invention to bond surfaces together with an apparatus and method that is safe in use.

It is yet another object of the present invention to discrete wire bond to thin gold surfaces.

These and other objects of the invention will become more apparent after referring to the following description considered in conjunction with the accompanying drawings.

The objects of the invention have been achieved by, according to one aspect of the invention, providing a bonding apparatus comprising:
a bonding tip at least a part of which is conically shaped having an open end and a closed end, said bonding tip tapering from said open end to said closed end;

a source of ultrasonic energy cooperatively engaged with said bonding tip;

a source of laser energy; and

an optical fiber extending from said laser energy source to the interior of said bonding tip, said optical fiber capable of transmitting a laser beam from said laser energy source to said closed end of said bonding tip so as to locally heat said closed end.

According to a second aspect of the invention, there is provided a bonding apparatus for discrete wire bonding comprising:

a bonding tip at least a part of which is conically shaped having an open end and a closed end, said bonding tip tapering from said open end to said closed end;

a source of ultrasonic energy cooperatively engaged with said bonding tip so that ultrasonic energy is transmitted to said bonding tip;

a source of laser energy; and

an optical fiber extending from said laser energy source to the interior of said bonding tip, said optical fiber capable of transmitting a laser beam from said laser energy source to said closed end of said bonding tip so as to locally heat said closed end;

said ultrasonic energy and heated bonding tip causing wire bonding to occur.

According to a final aspect of the invention, there is provided a bonding apparatus comprising:

a bonding tip at least a part of which is conically shaped having an open end and a closed end, said bonding tip tapering from said open end to said closed end;

a source of laser energy; and

an optical fiber extending from said laser energy source to the interior of said bonding tip, said optical fiber capable of transmitting a laser beam from said laser energy source to said closed end of said bonding tip so as to locally heat said closed end.

## BRIEF DESCRIPTION OF THE DRAWINGS

Figure 1 is a schematic view of the bonding apparatus according to the invention.

Figure 2 is an enlarged cross sectional view of the bonding tip according to the invention.

Figure 3 is a bar graph comparing the effectiveness of ultrasonic bonding with laser assisted ultrasonic bonding according to the invention.

## DETAILED DESCRIPTION OF THE INVENTION

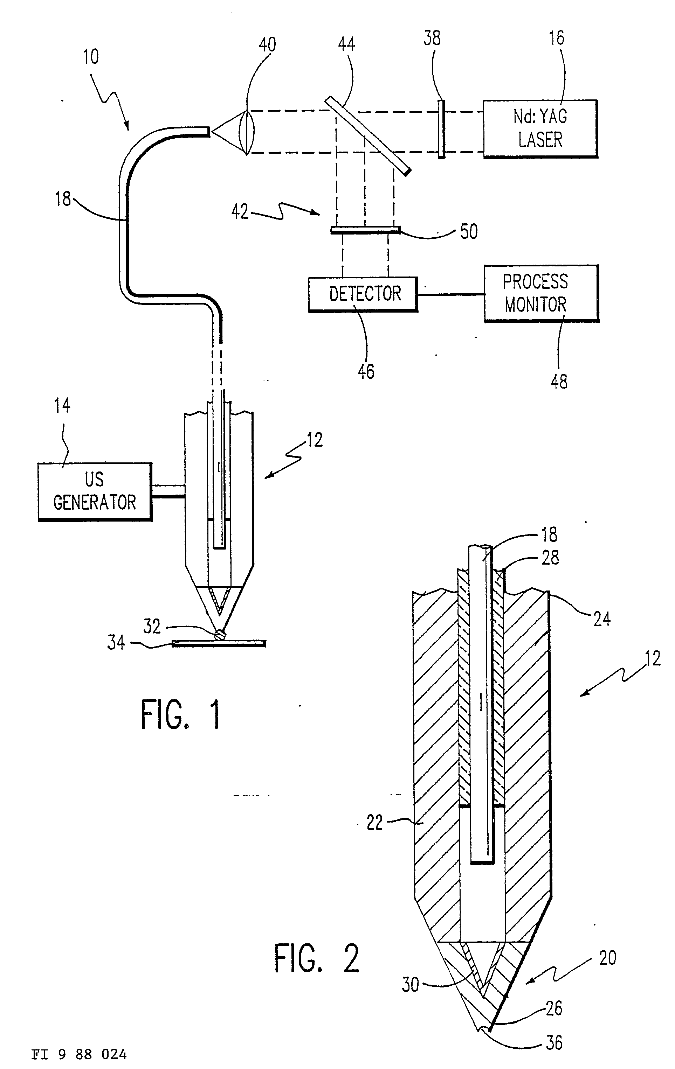

Referring to the drawings in more detail, and particularly referring to Figures 1 and 2, there is illustrated according to the invention a bonding apparatus, generally indicated by 10. The bonding apparatus comprises a bonding tip, generally indicated by 12, a source of ultrasonic energy 14 cooperatively engaged with the bonding tip 12, a source of laser energy 16 and an optical fiber 18 extending from the laser 16 to the bonding tip 12.

Bonding tip 12 is placed upon the item to be bonded which for present purposes is wire 32. Upon operation of the bonding apparatus 10 (to be explained in more detail hereafter), wire 32 is bonded to substrate 34.

Referring now particularly to Figure 2, an enlarged view of the bonding tip 12 shows the bonding tip 12 in much greater detail. The bonding tip 12 has at least a part 20 which is conically shaped. The entire tip may be conically shaped if desired but this would be a waste of material. Rather, conically shaped part 20 extends from shank 22, which may be, for example, circular or rectangular in cross section. Bonding tip 12 is hollow such that there is an open end 24 and a closed end 26. The interior of bonding tip 12 tapers from the open end 24 to the closed end 26. Within the interior of bonding tip 12, there is an insulating sleeve, or more preferably, a ceramic sleeve 28 which fits snugly within the bonding tip cavity. The optical fiber 18 is positioned within the ceramic sleeve 28 which serves to coaxially align the optical fiber 18 with the closed end 26 of the bonding tip 12. The ceramic sleeve 28 also prevents relative movement between the optical fiber 18 and bonding tip 12 during the ultrasonic oscillation. The ceramic sleeve 28 may be made from any ceramic material such as alumina.

Bonding tip 12 may optionally comprise an optical coating 30 on the interior of the closed end 26 of the bonding tip. The optical coating 30 is absorbent with respect to the wavelength of the particular laser that is utilized. The optical coating 30 enhances the absorption of the laser energy and increases the overall light to heat energy conversion efficiency. Optical coating 30 may comprise, for example, chemical vapor deposited carbon or chrome oxide.

Instead of an optical coating, it has been found that if the interior of the closed end 26 of the bonding tip 12 is formed by electro discharge machining (EDM), the roughened surface achieves the desired effect of maximizing the absorbence of the laser energy without an optical coating. Of course, an optical coating may also be applied if desired.

Bonding tip 12 may further optionally comprise groove 36 on the bottom of the bonding tip 12 which enhances the thermal and mechanical coupling between the bonding tip 12 and wire 32.

The source of ultrasonic energy 14 may be provided by an ultrasonic generator as is well known to those skilled in the art. It is necessary for the ultrasonic generator to be cooperatively engaged or coupled, either directly or indirectly, to the bonding tip 12 so as to be able to transfer ultrasonic energy from the ultrasonic generator 14 to the bonding tip 12.

The particular source of laser energy which is preferred for the purposes of the present invention is a continuous wave Nd:YAG laser at 1.06 μm wavelength. A shutter 38 is situated in the laser tool to generate a laser pulse. Duration of the pulse is typically about 300 ms and power level ranges from 3-10 W. The laser beam is coupled to the optical fiber 18 by optical lens 40.

The particular kind of optical fiber utilized is normally made from high purity quartz and is often used for the transmission of power. Same optical fibers used for telecommunication purposes are unsatisfactory due to the fact that they may have a plastic coating which may melt within the bonding tip 12.

The optical fiber 18 then extends from the source of the laser energy to the interior of the bonding tip 12. The optical fiber is capable of transmitting the laser beam with minimal losses from the laser energy source·16 to the closed end 26 of the bonding tip. By virtue of the optical fiber 18, the laser energy may be precisely directed at the closed end 26 of the bonding tip 12 so as to provide local heating of the closed end 26 where it is actually needed. Minimal heat is transmitted to the remainder of the bonding tip by the laser, other than by conduction from the heated tip.

Due to the pulsing of the laser, the heating of the bonding tip 12 is intermittent. Intermittent heating has been found to be most desirable as it provides flexibility in fast heating of the wire 32 and substrate 34 while avoiding time-dependent thermal damages. The ultrasonic energy that is applied is also pulsed, typically for about 300 ms. The ultrasonic energy pulse may be applied before, after or during the laser pulse. It is preferred however that the laser and ultrasonic pulses overlap (asynchronous operation) with the laser pulse beginning first followed by the overlapping ultrasonic pulse about 100 ms later.

In operation, the bonding tip 12 is positioned over the wire 32. Asynchronous operation (preferably) of the laser and ultrasonic generator begin. The· bonding tip 12 reaches a maximum temperature of about 300 C which is insufficient to cause melting of the wire 32. By virtue of the heat and ultrasonic energy, the wire 32 becomes bonded to the substrate 34.

In the preferred embodiment of the invention, a discrete EC wire is bonded to an EC pad. The EC pad comprises a multilayered metallurgical structure consisting of, for example, titanium/copper/ nickel/gold. It would be desirable to have the gold thickness on the EC pads the same as the gold thickness on the chip sites in order to simplify the manufacturing process. The typical gold thickness on present day chip sites is on the order of 1000--2500Å. Ultrasonic bonding as taught in the prior art is unreliable when used for wire bonding to EC pads having this thickness of gold. According to the present invention, as will be demonstrated hereafter, wire bonding to EC pads having such thin gold is readily accomplished.

It should be understood that the preferred mode of operation of the present invention is such that the laser heating of the bonding tip and the applied ultrasonic energy should work together to effect the desired bond. It is, however, within the scope of the present invention for certain bonding steps to occur without the use of ultrasonic energy. For example, the bonding apparatus according to the present invention may be utilized for soldering where efficient heating of the bonding tip is desired. Other uses of the present invention will also come to mind. It should be understood that such other uses are within the scope of the present invention.

It has been found to be desirable to be able to monitor the temperature of the bonding tip during laser assisted ultrasonic bonding. Accordingly, the present invention further comprises means, generally indicated by 42, for determining the temperature of the closed end 26 of the bonding tip 12. While a simple thermocouple will work it is not the most effective temperature determining means as it only determines or measures the temperature before bonding or after bonding but not during bonding.

The preferred temperature determining means comprises a dichroic mirror 44 interposed between the bonding tip 12 and the laser energy source 16. Usually and preferably, the dichroic mirror 44 will be positioned within the laser tool itself as shown in Figure 1. Dichroic mirrors are well known to those skilled in the art. Such dichroic mirrors may be selective wavelength filters in that they are transparent to light shorter than a predetermined wavelength but are reflective to light longer than a predetermined wavelength. For the present invention, the dichroic mirror 44 allows light of the same wavelength of the laser energy source (for example, 1.06 μm for a Nd:YAG laser) to pass through the dichroic mirror 44 while reflecting light having a different and longer wavelength than the laser energy source.

In operation, the dichroic mirror 44 allows all the light from the laser 16 to be transmitted to the optical fiber 18 and then to the closed end 26 of the bonding tip 12. Upon heating of the bonding tip 12 by the laser light, the hot tip now becomes an efficient radiator of infra red light. A portion of this radiated infra red light is captured by the optical fiber and transmitted back towards the laser along with reflected laser light. As the reflected laser light and radiated infra red light emerge from the fiber, they are collimated by lens 40. The reflected laser light, having a wavelength of 1.06 μm (assuming a Nd:YAG laser), is transmitted through the dichroic mirror 44. The radiated infra red light, having a wavelength longer than 1.06 μm , is reflected with little loss by the dichroic mirror 44 to detector means 46 which is sensitive to infra red light. The detector 46 may be callibrated to give the instantaneous temperature of the bonding tip 12. Data from detector 46 fs fed to process control 48 which may adjust the output of laser 16 so as to maintain a constant temperature of the bonding tip 12.

Preferably, the temperature determining means further comprises a blocking filter 50 which is interposed between the dichroic mirror 44 and the detector 46. The blocking filter 50 blocks any remaining light having the same wavelength as the laser energy source. Thus, for a Nd:YAG laser, the blocking filter blocks light having a wavelength of 1.06 μm. The purpose of the blocking filter 50 is to remove all traces of reflected laser light which is much more intense than the radiated infra red light.

The advantages of the present invention will become more apparent after referring to the following test results.

TEST RESULTS

Ultrasonic bonding and laser assisted ultrasonic bonding were compared in a series of experiments.

A series of bonding experiments were conducted where gold coated copper alloy wire was bonded to an EC pad on an MLC substrate. The EC pad consisted of titanium/copper nickel with 2500Å of thin gold on top. The bonds were made using ultrasonic energy alone or ultrasonic energy with the bonding tip being heated with a Nd:YAG laser operating at 3 Watt and 280 ms pulse. The ultrasonic energy and laser were operated asynchronously with the ultrasonic pulse delayed by 100 ms. Six bonds were made at each ultrasonic power setting.

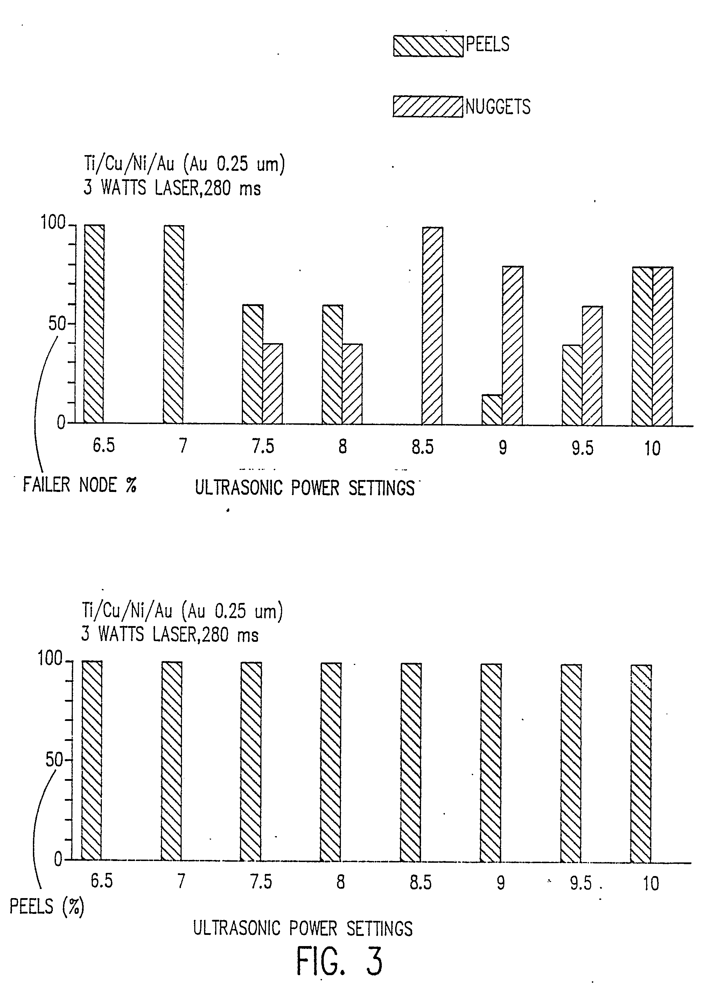

After bonding, the wires were pulled at a 30 degree angle to the substrate. If the wire was removed from the substrate, this was considered to be a peel and a failure. If the wire broke away from the bond surface, this was considered to be a nugget and a successful bond. The results are illustrated in Figure 3.

It is readily apparent that the laser assisted ultrasonic bonding is far superior to ultrasonic bonding alone. No nuggets were obtained when ultrasonic energy was used alone. In the case of laser assisted ultrasonic bonding, nuggets were obtained at most settings and at a setting of 8.5W, all nuggets were obtained with zero failures. It may then be concluded that laser assisted ultrasonic bonding would lead to successful bonding for thin gold of 2500Å whereas ultrasonic bonding alone would not.

Another advantage of the present invention is that for any given set of conditions, less ultrasonic energy is needed for optimum laser assisted ultrasonic bonding than for optimum ultrasonic bonding. This is an important advantage since excessive ultrasonic energy can damage certain substrates such as EC pads. Damage of this sort is less likely to occur with laser assisted ultrasonic bonding.

It will be apparent to those skilled in the art having regard to this disclosure that other modifications of this invention beyond those embodiments specifically described here may be made without departing from the scope of the invention. Accordingly, such modifications are considered within the scope of the invention as limited solely by the appended claims.

## Claims

1. A bonding apparatus comprising:
a bonding tip at least a part of which is conically shaped having an open end and a closed end, said bonding tip tapering from said open end to said closed end;
a source of laser energy; and
an optical fiber extending from said laser energy source to the interior of said bonding tip, said optical fiber capable of transmitting a laser beam from said laser energy source to said closed end of said bonding tip so as to locally heat said closed end.

2. A bonding apparatus according to Claim 1 further comprising a source of ultrasonic energy cooperatively engaged with said bonding tip.

3. The use of bonding apparatus of Claims 1 or 2 for discrete wire bonding in which the ultrasonic energy is transmitted to said bonding tip and, said ultrasonic energy and heated bonding tip causing wire bonding to occur.

4. The bonding apparatus according to anyone of Claims 1, 2 or 3, further comprising means for determining the temperature of said closed end of said bonding tip.

5. The bonding apparatus of Claim 4 wherein said temperature determining means comprises:

a dichroic mirror interposed between said bonding tip and said laser energy source, said dichroic mirror allowing light of the same wavelength as said laser energy source to pass through said dichroic mirror while reflecting light having a different wavelength than said laser energy source ; and
a detector means for detecting and measuring said reflected light.

6. The bonding apparatus of Claim 5 further comprising a blocking filter interposed between said dichroic mirror and said detector means, said blocking filter blocking light having the same wavelength as said laser energy source.

7. The bonding apparatus according to anyone of Claim 1 to 6 further comprising an optical coating at the closed end of said bonding tip wherein said optical coating is absorbent with respect to said source of laser energy.

8. The bonding apparatus according to anyone of Claim 1 to 7 further comprising an insulating sleeve inserted within said bonding tip and said optical fiber is positioned within said insulating sleeve.

9. The bonding apparatus of Claim 8 wherein said insulating sleeve comprises a ceramic material.

FIG. 1

FIG. 2

FI 9 88 024

FIG. 3